# EUROPÄISCHE PATENTANMELDUNG

(11) **EP 1 530 145 A2**
(43) Veröffentlichungstag der Anmeldung: **11.05.2005**
(21) Anmeldenummer: 04026503.5
(22) Anmeldetag: 09.11.2004
(51) Int. Cl.: G06K 5/00

(54) **Markierungsverfahren**

(30) Priorität: 09.11.2003 DE 10352561
(71) Anmelder: Jot Automation LET GmbH, 63839 Kleinwallstadt (DE)
(72) Erfinder: Liposcak, Stefan, 64850 Schaafheim (DE)
(74) Vertreter: Thürer, Andreas

(57) **Zusammenfassung**

Um Markierungen zuverlässig aufzubringen wird ein Adaptionsverfahren zur Erzeugung einer Markierung vorgeschlagen, die im Rahmen dieses Prozesses/dieser Prozesse und in der anschließenden Verwertung prozessbeständig und reproduzierbar lesbar ist, wobei zur Adaption zumindest eine Adaptionsmarkierung (1) auf ein Werkstück (5) aufgebracht wird, die zumindest eine Adaptionsmarkierung von einer Lesevorrichtung (2) gelesen wird, anschließend ausgewertet und mit einer Schwell-Güte (3) verglichen wird, bei Unterschreiten der Schwell-Güte zumindest ein Markierungsparameter (4) im Sinne einer Güteverbesserung angepasst, eine weitere Adaption wiederholt wird, bis die Schwell-Güte (3) erreicht ist und nach Erreichen der Schwell-Güte zumindest eine weitere Markierung unter Verwendung des/der angepassten Markierungsparameter(s) aufgebracht wird.

## Beschreibung

Die Erfindung betrifft ein Adaptionsverfahren des Aufbringens zumindest einer Markierung für einen darauffolgenden Fertigungs- und/oder Bearbeitungs- und/oder Verarbeitungsprozess.

Zur Wiedererkennung und Identifizierung, sowie zum Aufbringen wichtiger Produktinformationen ist es üblich, Markierungen mittels Laser, Klebeetiketten oder Farbauftrag auf Werkstücke, insbesondere Leiterplatten oder Leiterplattennutzen aufzubringen, die in späteren Verarbeitungsprozessen gelesen werden müssen.

Hierbei tritt häufig das Problem auf, das die Qualität der aufgebrachten Markierung zu schlecht oder zu schwankend ist, so dass kein zuverlässiges Resultat in einer ausreichend kurzen Zeit erreicht werden kann.

Aufgabe der vorliegenden Erfindung ist es, ein Verfahren bereitzustellen, dass es ermöglicht, Markierungen prozessbeständig und reproduzierbar auf Werkstücke, insbesondere Leiterplatten und Leiterplattennutzen aufzubringen

Die Aufgabe wird gelöst durch ein Adaptionsverfahren des Aufbringens zumindest einer Markierung für einen darauffolgenden Fertigungs- und/oder Bearbeitungsund/oder Verarbeitungsprozess, die im Rahmen dieses Prozesses/dieser Prozesse und in der anschließenden Verwertung prozessbeständig und reproduzierbar lesbar ist, wobei zur Adaption
1.1 zumindest eine Adaptionsmarkierung auf ein Werkstück, insbesondere eine Leiterplatte oder einen Leiterplattennutzen, aufgebracht wird,
1.2 die zumindest eine Adaptionsmarkierung von einer Lesevorrichtung gelesen wird,
1.3 das Leseergebnis hinsichtlich der Güte der Adaptionsmarkierung ausgewertet und mit einer Schwell-Güte verglichen wird,
1.4 bei Unterschreiten der Schwell-Güte zumindest ein Markierungsparameter im Sinne einer Güteverbesserung angepasst,
1.5 eine weitere Adaption 1.1 - 1.4 unter Verwendung des zumindest einen angepassten Markierungsparameters wiederholt wird, bis die Schwell-Güte erreicht ist und
1.6 nach Erreichen der Schwell-Güte zumindest eine weitere Markierung unter Verwendung des/der angepassten Markierungsparameter(s) aufgebracht wird.

Bei dem vorgeschlagenen Verfahren wird zunächst eine Adaptionsmarkierung zur Probe auf das Werkstück aufgebracht. Es kann sich um Markierungen unterschiedlichster Art handeln, die mit verschiedenen Verfahren aufgebracht werden können. Diese Markierung soll zur Gewährleistung eines sicheren und dauerhaften Erkennens während darauffolgender Verarbeitungsverfahren eine bestimmte Qualität, eine Schwell-Güte aufweisen. Die Güte der aufgebrachten Markierung wird durch einen Lesevorgang mit einer angeschlossenen Auswertung bestimmt, wobei sich die Gütekriterien für eine als notwendig angesehene Schwell-Güte je nach Verfahren der Aufbringung der Markierung sowie der aufgebrachten Markierung und den Anforderungen der anschließenden Verfahren unterscheiden können. Falls die Güte der Adaptionsmarkierung nicht ausreicht, werden Markierungsparameter verändert und eine weitere Adaptionsmarkierung aufgebracht, deren Güte wiederum bestimmt wird. Das Adaptionsverfahren ermöglicht es, die Güte einer Adaptionsmarkierung entweder in einem oder mehreren Probeläufen zu verbessern oder, falls beim ersten Durchlauf festgestellt wird, dass die Güte ausreicht, d.h. sofort die Schwell-Güte erreicht ist, die Adaptionsmarkierung direkt als Markierung für den weiteren Prozess zu verwenden.

Zur Beschleunigung des Prozesses sowie zur Sicherstellung einer gleichmäßigen Qualität ist es vorteilhaft, wenn die Markierung und/oder Adaptionsmarkierung maschinenlesbar ist und von einem Scanner, insbesondere einem Laserscanner, und/oder einem Kamerasystem und/oder einem Lichtsensor abgetastet wird. Das Abtasten kann unter denselben Bedingungen vorgenommen werden, wie beispielsweise Licht, Winkel, Abstand, Geschwindigkeit, wodurch Lesefehler minimiert werden.

Eine Verringerung der Anzahl der Adaptionsdurchläufe ist möglich, wenn für verschiedene Materialien der Werkstücke, insbesondere Oberflächenmaterialien sowie darunter angeordnete Unterschichten der Leiterplatten, jeweils ein Satz Markierungsparameter zur Herstellung einer Markierung mit einer Qualität zumindest entsprechend der Schwell-Güte ermittelt und in eine Auswerteeinheit vorzugsweise der Lesevorrichtung eingespeist wird. Auf diese Weise können für Standard-Materialien schnelle und präzise Regelungen der Markierungsparameter stattfinden. Kriterien wie beispielsweise der Kontrast der Markierungen gegenüber seiner Umgebung können sich bei gleichem Oberflächenmaterial aber anderer Unterschicht stark ändern. Durch die vorgeschlagenen Verfahren kann auch auf einfache Weise eine Anpassung der Stärke der Markierung an die Unterschicht erfolgen.

Vorteilhaft ist es, wenn eines oder mehrere der folgenden Gütekriterien für den Vergleich der gemessenen Güte mit der Schwell-Güte maßgebend sind: - der Kontrast der Markierung gegenüber einem Markierungshintergrund, - der Farbumschlag, der durch den Markierungsvorgang entsteht, - die Farbechtheit, - Kontur- und Kantenschärfe, Anzahl der Konturen und Konturvollständigkeit der Markierung. Der Kontrast der Markierung ändert sich wesentlich mit dem Oberflächenmaterial einer Leiterplatte, das häufig ein Stopplack ist, sowie mit der darunterliegenden Unterschicht. Zudem kann im Laufe der Zeit eine Veränderung eintreten, wenn ein Material oxidiert oder sich in einer anderen Weise mit der Zeit ändert. Diese Materialeigenschaften können jedoch bereits beim Aufbringen berücksichtigt werden, und somit ein Nachlassen des Kontrasts beispielsweise durch einen stärkeren Auftrag kompensiert werden. Ein Farbumschlag hängt sehr stark von der Materialzusammensetzung ab. Kontur- und Kantenschärfe sind wesentlich für das Lesen sehr kleiner Strukturen mit einer großen Informationsdichte. Durch die Art der Markierung ist eine zu erreichende Form sowie ein bestimmter Informationsgehalt vorgeschrieben, was jedoch variieren kann, ist die Ausprägung der Markierung und ihre klare Abgrenzung.

Zeit und Arbeitsaufwand kann gespart werden, wenn an einem für eine Mehrzahl von Werkstücken repräsentativen Werkstück eine Adaption gemäß einem der Ansprüche 1 bis 4 durchgeführt wird und die ermittelten Markierungsparameter für die Markierung der Mehrzahl von Werkstücken verwendet werden.

Vorteilhaft ist es, wenn für Werkstücke, die voraussichtlich hinsichtlich der Markierungsparameter denselben relevanten Materialeigenschaften entsprechen, insbesondere Leiterplatten gleicher Charge und/oder mit gleichem Stoplack, jeweils nur für ein Werkstück ein Adaptionsverfahren vorgenommen wird und anschließend die Markierung(en) auf die entsprechenden Werkstücke mit den durch das Adaptionsverfahren ermittelten Markierungsparametern aufgebracht wird (werden). Vorraussetzung hierfür ist, dass das zur Adaption ausgewählte Werkstück in für die Markierungseigenschaften wesentlichen Punkten gleich oder sehr ähnlich zu den restlichen Werkstücken ist. Dabei sind insbesondere die Oberflächenbeschaffenheit sowie die Oberflächenmaterialzusammensetzung, besonders der Stoplack, der ein Verlaufen von Lötmaterial auf einer Leiterplatte verhindert, berücksichtigt.

Unterschiedlichste Werkstücke oder auch insbesondere Mischchargen, deren Trennung nach Materialien zu aufwendig ist, können schnell und sicher markiert werden, wenn für jedes Werkstück ein Adaptionsverfahren durchgeführt wird.

Zur Sicherstellung einer guten Markierungsqualität ist es vorteilhaft, wenn nach einem Umrüsten/ einer Inbetriebnahme ein Adaptionsverfahrensdurchlauf vorgenommen wird. Durch das Umrüsten/Inbetriebnahmen können sich wichtige Markierungsparameter wie beispielsweise der Abstand der Markierungsvorrichtung zum Werkstück verändert haben, was auf diese Weise einfach korrigiert werden kann.

Eine gut reproduzierbare Art der Markierungsaufbringung liegt vor, wenn die Markierung mit Hilfe eines Lasers, insbesondere eines CO₂-Lasers und/oder Nd-YAG-Lasers, einer Klebetechnik, oder einem Farbauftrag aufgebracht wird. Der CO₂-Laser ermöglicht insbesondere die Aufbringung sehr kleiner Markierungen mit einer großen Informationsdichte, die auf alle Stellen eines Werkstücks und insbesondere in eine Kunststoffoberfläche eingebracht werden können.

Eine gute Steuerung des Markierungsauftrags ist möglich, wenn die Markierungsparameter sind: die Laserleistung und/oder -pulsstärke und/oder -dauer, und/oder Auftragsgeschwindigkeit und/oder Farbzusammensetzung eines Farbauftrags.

Eine sehr flexibel auf verschiedene Prozesse und Produktionsdaten einstellbare sowie gut rückverfolgbare Markierungsform liegt vor, wenn die Markierungen aus einem Code zur Identifizierung bestehen, umfassend insbesondere Zahlen, die insbesondere Herstellerdaten, Zeit, Material entsprechen.

Ein mit einem geringen Arbeits- sowie Wartungsaufwand verbundenes Verfahren liegt vor, wenn das Verfahren als teil- oder vollautomatisches Verfahren eingerichtet ist, insbesondere als Teil eines Produktionsverfahrens. Insbesondere durch die geregelten, wiederholbaren Adaptionsdurchläufe ist es sichergestellt, dass einerseits nur eine Markierung mit ausreichender Qualität in die Produktion gelangt und dass andererseits die Markierung reproduzierbar und schnell hergestellt und kontrolliert werden kann.

Weitere Merkmale und Vorteile der Erfindung ergeben sich aus den Ansprüchen und der nachstehenden Beschreibung, in der Ausführungsbeispiele des Gegenstands der Erfindung in Verbindung mit den Zeichnungen näher erläutert sind.

Es zeigt:
- Fig. 1: eine schematische Darstellung des Aufbringens und Lesens einer Adaptionsmarkierung und
- Fig. 2: eine schematische Darstellung eines Adaptionsverfahrens.

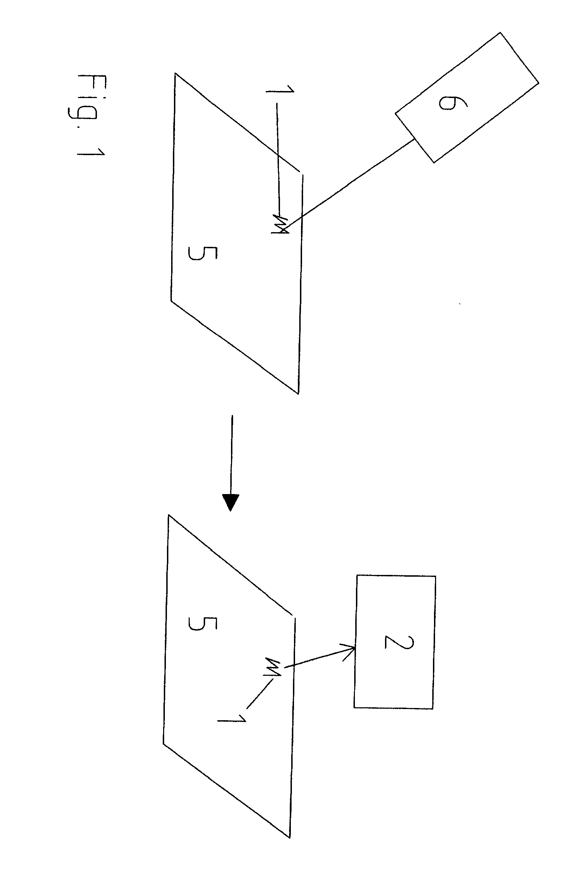

Fig. 1 zeigt eine schematische Darstellung des Aufbringens und Lesens einer Adaptionsmarkierung. Auf ein Werkstück 5, insbesondere eine Leiterplatte, wird eine Adaptionsmarkierung 4 mittels einer Auftragungsvorrichtung, insbesondere einem Laser 6, aufgebracht. Die Markierung besteht aus einer Vielzahl von codierten Informationen auf engem Raum, so dass scharfe Konturen und Kontraste notwendig sind, um eine gute, reproduzierbare Leseergebnis während eines weiteren Produktionsablaufes zu erhalten. Um dies zu gewährleisten, wird ein Regelkreis durchlaufen, der zu einer Markierung mit ausreichender Qualität führt.

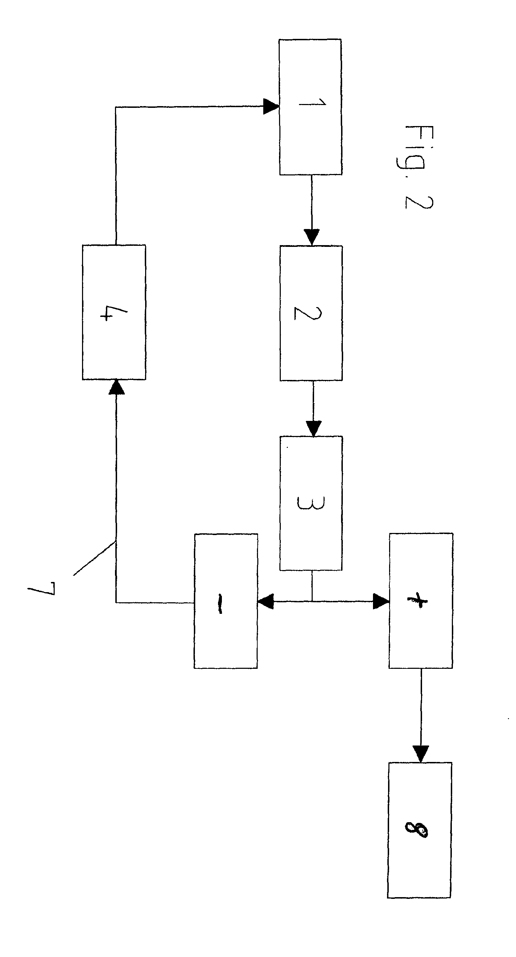

Fig. 2 zeigt eine schematische Darstellung eines Adaptionsverfahrens. Eine Adaptionsmarkierung 1 wird auf ein Werkstück aufgebracht, von einer Lesevorrichtung gelesen und eine hieraus errechnete Güte mit einer Schwell-Güte 3 verglichen. Wenn die Güte die Schwell-Güte 3 erreicht hat, kann die Adaptionsmarkierung 1 direkt als Markierung für einen weiteren Produktionsprozess verwendet werden. Eine Adaptionsmarkierung 1, die diese Schwell-Güte 3 nicht erreicht, durchläuft einen Regelprozess 7, in dem eine Änderung der Markierungsparameter 4 erfolgt und mit diesen neuen Markierungsparametern 4 eine neue Adaptionsmarkierung 1 aufgetragen wird, die wiederum gelesen und deren Güte mit der Schwell-Güte 3 verglichen wird.

Dieser Adaptionsprozess wird so lange wiederholt, bis die Schwell-Güte 3 erreicht wurde.

### BEZUGSZEICHENLISTE

- 1: Adaptionsmarkierung
- 2: Lesevorrichtung
- 3: Schwell-Güte
- 4: Markierungsparameter
- 5: Werkstück
- 6: Laser
- 7: Regelkreis
- 8: Produktionsprozess

## Patentansprüche

1. Adaptionsverfahren des Aufbringens zumindest einer Markierung für einen darauffolgenden Fertigungs- und/oder Bearbeitungs- und/oder Verarbeitungsprozess, die im Rahmen dieses Prozesses/dieser Prozesse und in der anschließenden Verwertung prozessbeständig und reproduzierbar lesbar ist, wobei zur Adaption
1.1 zumindest eine Adaptionsmarkierung (1) auf ein Werkstück (5), insbesondere eine Leiterplatte oder einen Leiterplattennutzen, aufgebracht wird,
1.2 die zumindest eine Adaptionsmarkierung (1) von einer Lesevorrichtung (2) gelesen wird,
1.3 das Leseergebnis hinsichtlich der Güte der Adaptionsmarkierung (1) ausgewertet und mit einer Schwell-Güte (3) verglichen wird,
1.4 bei Unterschreiten der Schwell-Güte (3) zumindest ein Markierungsparameter (4) im Sinne einer Güteverbesserung angepasst,
1.5 eine weitere Adaption 1.1 - 1.4 unter Verwendung des zumindest einen angepassten Markierungsparameters (4) wiederholt wird, bis die Schwell-Güte (3) erreicht ist und
1.6 nach Erreichen der Schwell-Güte (3) zumindest eine weitere Markierung unter Verwendung des/der angepassten Markierungsparameter(s) (4) aufgebracht wird.

2. Adaptionsverfahren nach Anspruch 1, **dadurch gekennzeichnet, dass** die Markierung und/oder Adaptionsmarkierung (1) maschinenlesbar ist und von einem Scanner, insbesondere einem Laserscanner, und/oder einem Kamerasystem und/oder einem Lichtsensor abgetastet wird.

3. Adaptionsverfahren nach Anspruch 1 oder 2, **dadurch gekennzeichnet, dass** für verschiedene Materialien der Werkstücke (5), insbesondere Oberflächenmaterialien sowie darunter angeordnete Unterschichten der Leiterplatten, jeweils ein Satz Markierungsparameter (4) zur Herstellung einer Markierung mit einer Qualität zumindest entsprechend der Schwell-Güte (3) ermittelt und in eine Auswerteeinheit vorzugsweise der Lesevorrichtung eingespeist wird.

4. Adaptionsverfahren nach einem der Ansprüche 1 bis 3, **dadurch gekennzeichnet, dass** eines oder mehrere der folgenden Gütekriterien für den Vergleich der gemessenen Güte mit der Schwell-Güte (3) maßgebend sind: - der Kontrast der Markierung gegenüber einem Markierungshintergrund, - der Farbumschlag, der durch den Markierungsvorgang entsteht, - die Farbechtheit, - Kontur- und Kantenschärfe, Anzahl der Konturen und Konturvollständigkeit der Markierung.

5. Adaptionsverfahren nach einem der Ansprüche 1 bis 4, **dadurch gekennzeichnet, dass** an einem für eine Mehrzahl von Werkstücken repräsentativen Werkstück (5) eine Adaption gemäß einem der Ansprüche 1 bis 4 durchgeführt wird und die ermittelten Markierungsparameter (4) für die Markierung der Mehrzahl von Werkstücken verwendet werden.

6. Adaptionsverfahren nach Anspruch 5, **dadurch gekennzeichnet, dass** für Werkstücke (5), die voraussichtlich hinsichtlich der Markierungsparameter denselben relevanten Materialeigenschaften entsprechen, insbesondere Leiterplatten gleicher Charge und/oder mit gleichem Stoplack, jeweils nur für ein Werkstück (5) ein Adaptionsverfahren vorgenommen wird und anschließend die Markierung(en) auf die entsprechenden Werkstücke (5) mit den durch das Adaptionsverfahren ermittelten Markierungsparametern (4) aufgebracht wird (werden).

7. Adaptionsverfahren nach einem der Ansprüche 1 bis 6, **dadurch gekennzeichnet, dass** für jedes Werkstück (5) ein Adaptionsverfahren durchgeführt wird.

8. Adaptionsverfahren nach einem der Ansprüche 1 bis 7, **dadurch gekennzeichnet, dass** nach einem Umrüsten/ einer Inbetriebnahme ein Adaptionsverfahrensdurchlauf vorgenommen wird.

9. Adaptionsverfahren nach einem der Ansprüche 1 bis 8, **dadurch gekennzeichnet, dass** die Markierung mit Hilfe eines Lasers (6), insbesondere eines CO₂-Lasers und/oder Nd-YAG-Laser, einer Klebetechnik, oder einem Farbauftrag aufgebracht wird.

10. Adaptionsverfahren nach einem der Ansprüche 1 bis 9, **dadurch gekennzeichnet, dass** die Markierungsparameter (4) sind: die Laserleistung und/oder - pulsstärke und/oder -dauer, und/oder Auftragsgeschwindigkeit und/oder Farbzusammensetzung eines Farbauftrags.

11. Adaptionsverfahren nach einem der Ansprüche 1 bis 10, **dadurch gekennzeichnet, dass** die Markierungen aus einem Code zur Identifizierung bestehen, umfassend insbesondere Zahlen, die insbesondere Herstellerdaten, Zeit, Material entsprechen.

12. Adaptionsverfahren nach einem der Ansprüche 1 bis 11, **dadurch gekennzeichnet, dass** es als teil- oder vollautomatisches Verfahren eingerichtet ist, insbesondere als Teil eines Produktionsverfahrens.
